# EUROPEAN PATENT APPLICATION

(11) **EP 3 459 653 A1**
(43) Date of publication of application: **27.03.2019**
(21) Application number: 17192059.8
(22) Date of filing: 20.09.2017
(51) Int. Cl.: B22F 3/105, B22F 3/15, B22F 5/00, B22F 5/04, C23C 4/073, B33Y 80/00, B33Y 10/00, B22F 3/24

(54) **METHOD FOR MANUFACTURING A COMPONENT AND COMPONENT**

(71) Applicant: Siemens Aktiengesellschaft, 80333 München (DE)
(72) Inventor: Karlsson, Fredrik, 61691 Åby (SE)

(57) **Abstract**

The invention relates to a method for manufacturing a component (2), wherein a preform (4) is shaped in an additive manufacturing process (AMP), a surface of the preform (4) is coated within a coating process (CP), and the coated preform is hydrostatically compacted in a compacting process (HCP).

## Description

The present invention relates to a method for manufacturing a component, wherein a preform is shaped in an additive manufacturing process. Further the invention relates to a correspondingly manufactured component.

In an additive manufacturing process (e.g. a rapid prototyping process or a rapid manufacturing process) a three dimensional component is shaped from a raw material in a layer-wise manner. For example, selective laser melting (SLM) or electron beam melting (EBM) methods use a powder as a raw material, which is molten by a laser or an electron beam respectively, to form the layers of the component. In a stereolithography process - as another example for an additive manufacturing process - a photosensitive polymer resin is used as a raw material, which is photochemically solidified by means of an ultraviolet (UV) laser to form a layer of the component.

By means of an additive manufacturing process it possible to build a component with a comparatively complex or convoluted geometry. In particular it is possible to realize geometries which cannot be built using non additive processes like casting or stamping processes or there is at least one additional step necessary in non additive processes to achieve the net-shape of the component.

In contrast, in additive manufacturing processes the component is manufactured in net-shape or at least in so called "near net-shape", making it possible to omit further manufacturing steps, thus resulting in a comparatively short manufacturing time.

However, during additive manufacturing, process-related defects such as pores (a porosity) or solidification cracks can occur. Those defects are detrimental to mechanical properties and therefore should be removed or avoided.

Internal pores (closed porosity), which are located within the component and are not connected to the surface of the component, can be removed or are at least reduced for example by means of hydrostatic compacting processes such as a hot isostatic pressing (HIP) process. However, pores that are connected to the surface of the component, hereinafter referred to as surface connected pores, and solidification cracks cannot be closed by this method. This is due to the fluid exerting the hydrostatic pressure onto the component, also entering the surface connected pores and cracks in the compacting process.

On account of theses defects there are restrictions on the material composition of the component that can be used in the additive process, if said defects are unacceptable for the intended use of the component. In order to reduce such defects, production parameters are altered for instance, or alternatively a different material composition, that is suited for the intended use, is used.

Nevertheless, superalloys, in particular Nickel based superalloys, whose intended use are high temperature resistant components such as gas path components for turbine blades and vanes, are comparatively difficult to manufacture by means of an additive manufacturing process in the necessary quality, that is low on defects.

It is an object of the present invention to enable manufacturing of an improved component. Furthermore, it is an object of the present invention to provide an improved component.

According to the invention, in view of manufacturing an improved component said object is achieved by a method with the characteristics of claim 1. In view of the improved component, the object is achieved according to the invention by a component with the characteristics of claim 10 Advantageous developments and embodiments are described in the dependent claims and in the following specifications.

The method is used for manufacturing a component. Within a first step of the method, a preform is shaped in an additive manufacturing process. In a second step, the preform is coated in a coating process. In a third step, which is preferably performed subsequently to the second step, the coated preform is hydrostatically compacted preferably such that the preform is compacted to its net shape resulting in said component.

Preferably, the preform is shaped in the additive manufacturing process layer-wise from a raw material according to a manufacturing model of the component. In this process production-related defects can occur. A defect is here understood to be especially a solidification crack or a pore (porosity), wherein that pore is either connected to the surface of the preform or closed (internal pore), the latter meaning that the respective pore is located completely within the preform and is not connected to the preform's surface, thus being separated from an environment, which surrounds the preform.

The surface is coated especially with a continuous layer (coating), preferably such that the preform is completely covered by the layer. By that means the cavity-like and surface connected defects, which appear during the additive manufacturing process, in particular the surface connected pores and - if applicable - solidification cracks, are sealed. In other words, the cavity of a defect is separated from the environment, which surrounds the component, by means of the continuous layer.

The surface, which is coated, is understood to include especially the surface of a model-based (e.g. intended or deliberately designed) structure of the preform, which may for example extend also into the body of the preform such as a cooling channel within a turbine blade, i.e. may also be formed as an undercut. For that purpose the coating material is prefereably applied to essentially (at least approximately) the whole model-based structure of the perform, in particular including intended undercuts.

The coating layer preferably has a sufficient thickness such that surface connected defects are closed. As an advantageous consequence it is facilitated that in the hydrostatic compacting step the defects' cavities stay closed. Thus, it is prevented that the fluid, which applies the pressure within the hydrostatic compacting process enters the defects' cavities. Preferably the coating layer is furthermore applied with a thickness such that it doesn't get damaged, for example breaks or tears, within the hydrostatic compacting process. For example, the coating layer has a thickness of 3-70 µm. Generally, a coating layer thickness of 3-10 µm would close surface connected defects. However, in view of coating even complex shaped preforms in an as reproducible and feasible manner as possible, expediently, a coating thickness of 10-60, preferably 20-50 µm is used. By reason of sealing the defects, it is facilitated to produce a pressure difference between the respective sealed defect's cavity and the surrounding environment, i.e. the surrounding atmosphere. Due to this comparatively high pressure difference the preform's internal pores as well as the sealed defects' cavities can be compacted (pressed) and at least partially removed. Thus, due to the coating, the sealed defects, in particular the surface connected pores as well as solidification cracks if present, are entirely or at least partially removed in the third step, thus expediently resulting in an as dense and as crack-free component as possible.

In an expedient embodiment hot isostatic pressing (HIP) is used in the third step. This means that during the compacting step a comparatively high temperature is applied to the preform. Depending on the used raw material, the applied high temperature is for example greater than 400°C or greater than 1200°C, especially the temperature is between 1200°C and 1350°C, preferably in the range about 1210 or 1240°C. Due to that high temperature within the hot isostatic pressing process the preform is advantageously sintered to a preferably massive component in the same process step in that the compacting occurs. That means, applying a comparatively high hydrostatic pressure in the third compacting step on the coated preform in combination with the heat treatment of the preform causes for example plastic deformation, diffusion bonding or creep or a combination of those in the preform such that the preform is sintered resulting in the preferably massive component, wherein the coated defects as well as the internal pores are at least partially removed.

In a further development, the preform is charged with a low pressure, preferably a vacuum in the sealing (i.e. coating) step. Hereby, the low pressure or respectively the vacuum is applied onto the preform expediently before the surface is coated. A low pressure is here to be understood as a pressure which is lower than the atmospheric (barometric) pressure, e.g. less than 10⁻⁵ Pa. By that the defects' cavities are evacuated from air or from a gas, which for example surrounds the raw material during the additive process as kind of an environmental atmosphere and thus is also in the defects' cavities, or alternatively enters the defects' cavities during transport of the preform from a facility used for the additive manufacturing process to a facility used for the coating process. As a consequence, especially the surface connected defects' cavities that are sealed during the coating process do not contain any gas or at least a comparatively low amount of gas thus preserving the low pressure or the vaccum, repectively. This leads to improved compacting of the coated preform during the third step. This is due to the fact that the pressure of any gas entrapped in the defects' cavities as well as gas entrapped in internal pores would function as a resistance against the hydrostatic pressure applied on the preform's surface during the compacting process and would, thus, prevent or at least diminish the desired compacting. Additionally, the resulting only partially compacted defects would enclose gas under increased pressure. As a consequence, that comparatively high internal gas pressure would add stress locally. Furthermore, due to those partially compacted defects fatigue resistance of the (final) component could be reduced, especially in respect to crack initiation.

In an expedient embodiment chemical vapor deposition (CVD) is used to coat the surface of the preform. With this method it is advantageously possible to coat the entire surface of the preform with a layer of sufficient thickness. Expediently, a structure of the preform, which especially extends into the body of the preform (i.e. undercuts or other intended cavities such as bores) may be coated by flowing the vapor through such structure, also. That means, by way of chemical vapor deposition it is possible to coat an area of the surface of the preform, which does not have free line of sight to the source of the coating material. Furthermore, the defects' cavities are advantageously evacuated before the surface is coated, especially when low-pressure chemical vapor deposition (LPCVD) or preferably ultrahigh vacuum chemical vapor deposition (UHVCVD) is used in the coating step.

Alternatively, other coating techniques can be used to coat the preform. For example a preform can be coated by means of vacuum plasma spray (VPS), low pressure plasma spray (LPPS) or electron beam physical vapor deposition (EB-PVD). Advantageously within those methods a low pressure is applied on the preform. These methods are suited especially for coating a preform, which comprises no structures that extend into the preform's body such as an undercut.

According to an advantageous development of the invention, in the additive manufacturing process a powder is used as the raw material from which the preform is shaped. The powder is preferably being melted (especially merely or only) partially, in particular by adjusting the power input (energy input in a given amount of time) into the raw material. The power input into the powder is adjusted preferably by altering the parameters of the additive manufacturing process, for example parameters of a radiation beam, which is used for melting the powder. This is achieved in particular by altering the power output of the source of the radiation beam or by altering the focus diameter of a focal spot of the radiation beam, thus altering the radiated area of the powder, or by altering a scanning speed of the radiation beam, thus altering the energy input in the radiated area of the raw material in a specific amount of time, or a combination of those. Optionally, parameters which do not alter the radiation beam such as a temperature for preheating the raw material are adjusted, additionally. The process parameters are in particular dependent on the used powder. For example the powder's mean grain size, its reflectivity or absorption coefficient are considered for adjusting the power input accordingly. In summary, the power input into a given (radiated) area of raw material is adjusted depending on the used raw material such that the raw material is being melted only partially.

Partially melting is here to be understood such that especially a single radiated grain of the powder is not being melted entirely, i.e. that it is not molten entirely. In particular the grain's surface is being melted, whereas its core remains non-molten. However, as a result of manufacturing tolerances, in particular a size distribution of the grains, it is possible that, when radiating an area of the powder, comparatively small grains may already be molten entirely while the majority of the grains are merely partially molten as intended. In summary, the power input is adjusted especially such that for example more than 80%, preferably more than 90%, of the grains is being melted merely partially.

By means of merely partially melting the powder, its volumetric shrinkage is reduced advantageously when the molten phase of the powder, in particular of the respective grains, cools and solidifies. As an advantageous consequence solidification cracks can be avoided or at least reduced.

Preferably, the powder is partially molten in such a way, that the preform is sufficiently stable to be handled, for example to be transported from the facility performing the additive manufacturing process to the facility performing the coating process (that is also called "handling stability"). That means for partially melting the powder and additionally ensuring a sufficient handling stability of the preform, there is a minimum amount of energy input into a specific area of the powder required such that a sufficient amount of the powder's grains are bonded together as the molten part of the powder solidifies. That minimum amount of energy is preferably applied during the additive manufacturing process.

In an expedient embodiment the raw material is being partially melted such that the preform's porosity is sufficiently low to obtain a predictable (and preferably repeatable) shrinkage of the preform during the hydrostatic compacting step. That means that the intended net shape of the component is achieved in accordance with the predicted shrinkage of the coated preform during the compacting step. This is achieved by melting a sufficient amount of the powder, especially a sufficient amount of each grain.

According to a further advantageous development of the invention the powder is preferably being melted partially such that as much pores, which occur in the preform in the additive manufacturing process, as possible are surface connected. That means, by way of merely partially melting the powder within the additive manufacturing process a high volume fraction, for example more than 50%, especially more than 70% or preferably more than 90% of pores is being connected to the preform's surface. This is in particular advantageous if the preform is shaped in an additive manufacturing process, wherein the powder is not charged with a vacuum, but wherein for example an inert shielding gas is used as an environmental atmosphere. If the volume fraction of surface connected pores, which are evacuated and sealed in the coating step, is comparatively high, merely a correspondingly small number of pores is internal pores. As an advantageous consequence the number of internal pores, which contain gas and therefore cannot be closed completely during the compacting process, is comparatively small. In order to achieve said high volume fraction of pores that are surface connected, a comparatively low power input or an accordingly low energy input into the powder is used, preferably. By means of partially melting the powder using a comparatively low power input into the powder there is comparatively little molten (liquid) powder such that completely enclosing a void between the single grains (thus forming an internal pore) is avoided.

However, in order to adjust the power input into the powder, in a preferably variant of the method, the following is considered: On the one hand the power input is sufficiently low to merely partially melt the powder, wherein as a consequence solidification cracks are avoided and a high volume fraction of the occurring pores are surface connected. On the other hand the power input into the powder has to be sufficiently high to obtain a predictable shrinkage of the preform in the third step and to ensure that the preform is sufficiently stable to be handled. As a consequence the parameters are adjusted under consideration of the powder's material characteristics to account for the above mentioned competing effects. In a particularly preferred variant, however, the parameters, especially the power input is chosen such that handling stability is facilitated just.

In an expedient embodiment, selective laser melting is used within the additive manufacturing process. In the selective laser melting process powder is used as a raw material and a laser is used as the radiation beam to melt the powder. The power input into the powder by the laser is adjusted as presented above such that the powder is melted merely partially by the laser.

In particular, for a metal based powder, electron beam melting is used alternatively within the additive manufacturing process. Herein, an electron beam is used as the radiation beam. Advantageously, in the electron beam melting process a vacuum is applied to the preform, such that internal pores contain no gas, which otherwise would diminish the intended compacting during the compacting step.

According to a further preferred embodiment, material used for the powder (which again is used within the additive manufacturing process to shape the preform) is a Nickel-based ("Ni-based") alloy, especially a Nickel-based superalloy. Preferably, a volume fraction of a γ'-phase of the Nickel-based alloy is between 10-70 %, in particular 20-60%, especially 30-50%. Advantageously, said a component manufactured from a powder of Nickel-based (super-)alloy, is manufactured densly and without or at least with reduced surface connected defects by the described method.

As an alternative, a ceramic powder is used as the raw material for the additive manufacturing process.

In an expedient embodiment aluminum vapor is used within the coating process, preferably within the chemical vapor deposition process, especially to form an aluminide coating. Advantageously an aluminide coating increases an oxidation resistance and provides protection against corrosion (especially Type II corrosion) for the component (especially by a combination with Platinum). Further advantageously an aluminide coating is comparatively easy to produce by chemical vapor deposition.

Alternatively, a MCrAlY is applied as coating material to the preform preferably by a vacuum plasma spray (VPS) or a low pressure plasma spray (LPPS) process. Therein M is an element or a combination of elements selected from the group consisting especially of Chromium (Cr), Nickel (Ni) or Cobalt (Co). Optionally, said coating material comprises as an addition Hafnium (Hf), Lanthanum (La), Tantalum (Ta) or Rhenium (Re).

The component according to the invention is formed from a preform that is shaped in an additive manufacturing process, preferably by selective laser melting. That preform is coated preferably by chemical vapor deposition and, afterwards, the coated preform is hydrostatically compacted preferably by using hot isostatic pressing. In summary, the component according to the invention is manufactured by means of the method described above. Thus, the inventive component shares the same advantages as the method described above.

In the following, an embodiment of the present invention is explained with reference to the attached drawing.
- FIG 1: shows a flowchart diagram schematically illustrating one embodiment of the method for manufacturing a component, wherein a preform is manufactured, coated and compacted to form the component,
- FIG 2: schematically shows the preform, comprising an internal pore, surface connected pores and a solidification crack, during a coating step,
- FIG 3: schematically shows the coated preform, wherein the surface connected pores and the solidification crack are sealed by means of the coating,
- FIG 4: shows schematically the compacted preform, wherein the surface connected pores as well as the solidification crack is removed,

Corresponding parts are provided with the same reference numerals in all figures.

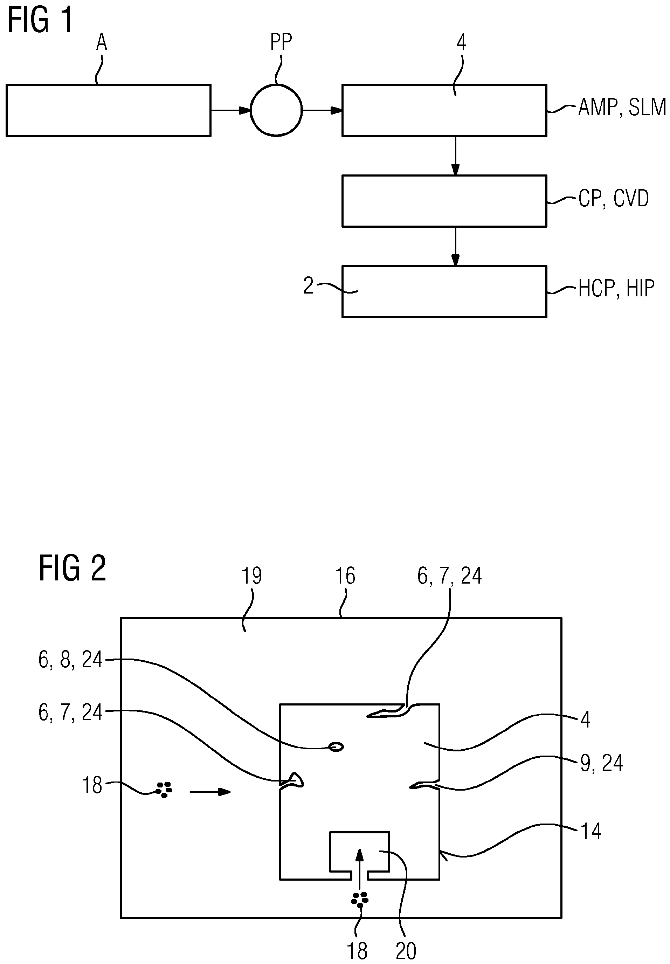

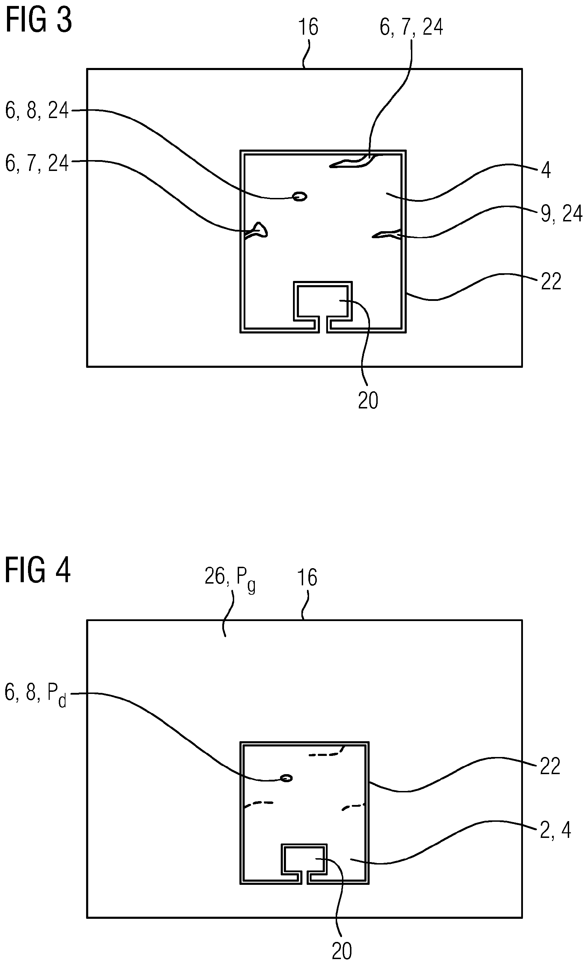

The flowchart diagram of FIG 1 illustrates a method of manufacturing a component 2 (FIG 4) in three steps. In a first step a preform 4 (FIG 2 to 4) is shaped in an additive manufacturing process AMP. In a second step the preform 4 is coated in a coating process CP. In a subsequent third step the coated preform 4 is hydrostatically compacted, further referred to as a hydrostatic compacting process HCP.

During manufacturing of the component 2 by means of an additive manufacturing process AMP, defects such as pores 6, which can be formed either as surface connected pores 7 or internal pores 8, and solidification cracks 9 occur process-related. By manufacturing a component 2 according to the method as shown in FIG 1, solidification cracks 9 are avoided and pores 6, in particular surface connected pores 7, are removed.

According to the embodiment of FIG 1, selective laser melting SLM is used within the additive manufacturing process AMP. The preform 4 is shaped layer-wise from a powder, which is molten partially by means of laser radiation. In the selective laser melting process SLM an inert shielding gas, for example argon or nitrogen, is used to form the environmental atmosphere surrounding the preform 4.

In this embodiment a material used for the powder from which the component 2 is manufactured is a Nickel-based alloy.

In order to partially melt the powder, the process parameters PP of the additive manufacturing process AMP are adjusted (Adjustment A). For that purpose the power output of the laser beam's source and, thus, the energy input into a given area of the powder is adjusted under consideration of the powder's properties such as its mean grain size and/or reflectivity. In particular the power output of the source of the laser, a focus diameter of the laser's focal spot or the laser's scanning speed is altered accordingly.

Preferably, the powder is being partially melted. I.e., merely a comparatively small part of each grain of the powder is molten, thus reducing the volumetric shrinkage as the molten part of the powder cools and solidifies. As a consequence solidification cracks 9 are avoided. As another result of partially melting the powder, a high volume fraction of the process-related occurring pores 6 are surface connected pores 7. Additionally, the stability of the preform 4 is that low that a handling stability (i.e. a stability sufficient for handling, especially transport of the preform 4 between the respective manufacturing facilities of the respective process steps) is achieved "just". Thus, the preform 4 is comparable to a pressed green body.

In an alternative not shown, electron beam melting is used within the additive manufacturing process AMP.

In the second step, as it is also shown in FIG 2 in more detail, the surface 14 of the preform 4 is coated by means of chemical vapor deposition CVD. The preform 4 comprises solidification cracks 9 as well as an internal pore 8 and surface connected pores 7. For the purpose of an improved clarity merely one solidification crack 9 and three pores 6, of which two are surface connected pores 7, are shown and for the purpose of an improved visibility those defects are shown in a larger scale.

The preform 4 is introduced into a chamber 16. The chamber 16 is charged with a vacuum 19 (i.e. the chamber 16 is evacuated or a low pressure is applied within the chamber 16) and subsequently the coating vapor 18 is flowed over the surface 14 of the preform 4. Therein the coating vapor 18 is composed of aluminum vapor. The coating vapor 18 is also flowed through an internal cavity ("undercut 20") of the preform 4. As is shown in FIG 3, a continuous coating layer 22 is formed by this means. As a consequence, the surface connected defects 7 and 9 are sealed. In other words a defect's cavity 24 of each surface connected pore 7 and the solidification crack 9 is separated from an environment or atmosphere surrounding the preform 4. Due to the evacuation before applying the coating the cavities 24 of the surface connected defects remain evacuated after the coating process CP is ended. As a consequence of melting the powder 4 such that as much of the pores 6 as possible are surface connected pores 7, only a minimum amount of pores 6 are formed as internal pores 8. Due to the fact that the internal pores 8 are formed in the selective laser melting process SLM and are separated from its surrounding atmosphere, those internal pores 8 are not evacuated in the second step but enclose the inert shielding gas.

In the third step, hot isostatic pressing HIP is used within the hydrostatically compacting process HCP in order to compact the preform 4 to its net shape. This means that the preform is deformed, in particular pressed to a smaller size. This step is shown in more detail in FIG 4. By means of a gas 26, a hydrostatic pressure P_{g} is applied onto the coated preform 4. By means of the coating layer 22 it is avoided that the gas 26 enters the surface connected pores 7 and the solidification crack 8. As a consequence, there is a pressure difference between the pressure P_{g} applied by means of the gas 26 and a pressure P_{d} in the defects 8 enabling the compacting of the surface connected defects. Additionally during the hydrostatically compacting process HCP the preform 4 is heated resulting in a sintering process of the preform 4. As a consequence of the sintering and the pressure P_{g} the surface connected pores 7 and the solidification crack are removed, which is represented by dashed lines of in the preform 4. By means of the hot isostatic pressing HIP the preform 4 is shaped in the intended net shape, or at least in so called "near net-shape" of the component 2.

The invention is not limited to the embodiments described above. Rather, other variants of the invention can also be derived therefrom without departing from the scope of the invention. In particular, all the individual features described in connection with the exemplary embodiments can also be combined with one another in another manner without departing from the subject matter of the invention.

## Claims

1. Method for manufacturing a component (2), wherein
- a preform (4) is shaped in an additive manufacturing process (AMP),
- a surface (14) of the preform (4) is coated in a coating process (CP), and
- the coated preform (4) is compacted in a hydrostatic compacting process (HCP).

2. The method according to claim 1,
wherein hot isostatic pressing (HIP) is used within the hydrostatic compacting process (HCP).

3. The method according to claim 1 or 2,
wherein within the coating process (CP) low pressure is applied onto the preform (4) .

4. The method according to one of the claims 1 to 3,
wherein within the coating process (CP) chemical vapor deposition (CVD) is used.

5. The method according to one of the claims 1 to 3,
wherein within the coating process (CP) a plasma spray is used.

6. The method according to one of the claims 1 to 5,
wherein within the additive manufacturing process (AMP) a powder is being melted partially to shape the preform (4).

7. The method according to claim 6,
wherein by means of partially melting the powder within the additive manufacturing process (AMP) a high volume fraction of pores (6) is being connected to the preform's surface (14) .

8. The method according to one of the claims 1 to 7,
wherein selective laser melting (SLM) is used within the additive manufacturing process (AMP).

9. The method according to one of the claims 6 to 8,
wherein a material used for the powder is a Nickel-based alloy.

10. The method according to one of the claims 1 to 9,
wherein aluminum vapor is used within the coating process (CP) .

11. The method according to one of the claims 1 to 9,
wherein a compound comprising chromium, aluminium and yttrium and additionally comprising one of chromium, nickel and cobalt is used as coating material within the coating process (CP) .

12. Component (2), manufactured by a method according to one of the claims 1 to 11.
